# EUROPEAN PATENT APPLICATION

(11) **EP 4 745 411 A1**
(43) Date of publication of application: **20.05.2026**
(21) Application number: 25215285.5
(22) Date of filing: 12.11.2025
(51) Int. Cl.: F04D 29/40, F04B 53/16, F04B 53/22, F04D 29/60, H05K 7/20

(54) **LIQUID PUMP UNIT WITH LATCH MECHANISM**

(30) Priority: 18.11.2024 TW 113212587 U
(71) Applicant: Cooler Master Co., Ltd., Taipei City 114065 (TW)
(72) Inventor: HAUNG, YU-LUN, 114065 Taipei City (TW)
(74) Representative: Grünecker Patent- und Rechtsanwälte PartG mbB

(57) **Abstract**

A liquid pump unit includes a chassis having a chassis box and a catch-pin with a retaining cut-out disposed in the chassis box, a pump assembly removably mounted in the chassis box, and a latch mechanism. The latch mechanism includes a latch having a main body portion pivotally mounted at a first location of the pump assembly, with a hook and an abutment protrusion projecting from opposite sides of the main body portion. A lever includes a pivot portion pivotally mounted at a second location on the pump assembly and an extension portion connected to the pivot portion. A bar has opposite first and second pivot ends pivotally connected to the main body portion and the extension portion, respectively. Rotation of the lever relative to the pump assembly and abutment of the abutment protrusion against the catch-pin cooperatively drive the hook to engage with the retaining cut-out.

## Description

### TECHNICAL FIELD

The present disclosure relates to liquid cooling systems, and more particularly to liquid pump units for liquid cooling system.

### BACKGROUND

In current server systems, multiple servers are arranged in an array within a cabinet. Each server may be equipped with components such as a processing module, a power supply module, a hard disk, and a liquid-cooling heat dissipation module, contingent upon functional requirements. Accordingly, the server system typically employs at least one coolant distribution unit to remove heat from the servers contained within the cabinet.

Typically, when an operator intends on changing a pump of the coolant distribution unit, the unit housing cover must be opened first. The original pump is then detached by releasing the fastening components, and the fluid pipelines and electrical connectors between the pump and the server must be disconnected. A new pump is subsequently installed, fastened, and connected to the fluid pipelines and electrical connectors to complete the replacement. However, the current assembly and disassembly procedures for coolant distribution units are overly complicated, resulting in inconvenience for operators during installation and maintenance. Therefore, there is still room for improvement in the ease with which coolant distribution units can be assembled and disassembled.

### SUMMARY

The invention is as defined in the appended claims. In general terms, this disclosure is directed to a liquid pump unit. In some embodiment, and by non-limiting example, the present disclosure provides a liquid pump unit having an exchangeable fluid supply body.

An aspect of the present disclosure provides a liquid pump unit. The liquid pump unit comprises a chassis including a chassis box and a catch-pin disposed on the chassis box, and the catch-pin has a retaining cut-out. The liquid pump unit also includes a pump assembly removably mounted in the chassis box, and a latch mechanism. The latch mechanism includes a latch having a main body portion, a hook, and an abutment protrusion, the main body portion being pivotally mounted at a first location of the pump assembly, and the hook and the abutment protrusion being projected from opposite sides of the main body portion. The latch mechanism also includes a lever having a pivot portion and an extension portion. The pivot portion is pivotally mounted at a second location on the pump assembly, and the extension portion is connected to the pivot portion. The latch mechanism further includes a bar having opposite first and second pivot ends that are pivotally connected to the main body portion of the latch and the extension portion of the lever, respectively. Rotation of the lever relative to the pump assembly and abutment of the abutment protrusion against the catch-pin cooperatively drive the hook to engage with the retaining cut-out.

In some embodiments, the retaining cut-out has a first abutment surface, a first end of the catch-pin remote from the chassis box has a second abutment surface, the first abutment surface faces away from the second abutment surface, the hook has a third abutment surface, the abutment protrusion has a fourth abutment surface, the third abutment surface faces toward the fourth abutment surface, when the abutment protrusion is abutted by the catch-pin, the second abutment surface abuts against the fourth abutment surface, and when the hook engages with the retaining cut-out, the third abutment surface abuts against the first abutment surface.

In some embodiments, the chassis further includes a first fluid connector and a first electrical connector that are disposed in the chassis box, the pump assembly includes a pump main body, a second fluid connector, and a second electrical connector, the pump main body is removably mounted in the chassis box, the second fluid connector and the second electrical connector are disposed in the pump main body, and rotation of the lever drives the hook to engage with the retaining cut-out via the bar, thereby causing the second fluid connector to fluidly communicate with the first fluid connector and the second electrical connector to electrically connect with the first electrical connector.

In some embodiments, the pump main body includes a tray box, a pump, and an electric driver, the second fluid connector, the second electrical connector, the pump, and the electric driver are disposed in the tray box, and the electric driver is electrically connected to the pump and to the second electrical connector.

In some embodiments, the pump main body further includes a connecting pipe configured to connect the second fluid connector to the pump.

In some embodiments, the main body portion is pivotally mounted at one location on the tray box at a side adjacent to the hook and the abutment protrusion, the pivot portion is pivotally mounted at another location on the tray box, the first pivot end being pivotally connected to the main body portion at a side opposite to the hook and the abutment protrusion, and the second pivot end being pivotally connected to the extension portion of the lever.

In some embodiments, the lever further includes an operating portion connected to the pivot portion and projecting in a direction different from the extension portion, the operating portion being configured to drive the lever to rotate relative to the tray box.

In some embodiments, the latch mechanism further includes a handle, the lever drives the latch through the bar, and the handle is connected to the operating portion of the lever to enable actuation of the lever.

In some embodiments, a first connecting line extends between a side of the handle remote from the operating portion and the pivot portion pivotally mounted on the tray box, a second connecting line extends between the pivot portion pivotally mounted on the tray box and the extension portion pivotally connected to the second pivot end, and a length of the first connecting line is greater than or equal to 1.1 times a length of the second connecting line.

In some embodiments, a fourth connecting line extends between the main body portion pivotally connected to the first pivot end and the main body portion pivotally mounted on the tray box, a fifth connecting line extends between the main body portion pivotally mounted on the tray box and the hook abutting against the retaining cut-out, a sixth connecting line extends between the main body portion pivotally mounted on the tray box and the abutment protrusion abutting against the catch-pin, a length of the fourth connecting line is greater than or equal to 1.1 times a length of the fifth connecting line, and the length of the fourth connecting line is greater than or equal to 1.1 times a length of the sixth connecting line.

In some embodiments, an angle between the fifth connecting line and the sixth connecting line is greater than or equal to 10 degrees and less than or equal to 90 degrees.

In some embodiments, the pump main body further includes a control circuit board electrically connected to the second electrical connector and the electric driver.

In some embodiments, the tray box includes multiple ventilation openings, and the pump main body further includes a fan device disposed on the tray box and configured to generate cooling airflow passing through the ventilation openings.

Another aspect of the present disclosure provides a pump assembly for a liquid cooling system. The pump assembly comprises a pump main body including a tray box, a pump disposed in the tray box, a fluid connector disposed in the tray box, and an electrical connector disposed in the tray box. The pump assembly also includes a latch mechanism. The latch mechanism includes a latch having a main body portion, a hook, and an abutment protrusion, the main body portion being pivotally mounted on the tray box, and the hook and the abutment protrusion being projected from opposite sides of the main body portion. The latch mechanism also includes a lever including a pivot portion mounted on the tray box and an extension connected to the pivot portion. The latch mechanism further includes a bar pivotally connecting the main body portion to the extension portion. The lever is configured to drive the latch through the bar to engage the hook with a retaining cut-out of a catch-pin.

In some embodiments, the hook has an abutment surface configured to abut against a corresponding abutment surface of the retaining cut-out when the hook engages with the retaining cut-out.

In some embodiments, the lever further includes an operating portion connected to the pivot portion and extending in a direction different from the extension portion.

In some embodiments, the latch mechanism further includes a handle connected to the operating portion and configured to drive rotation of the lever.

In some embodiments, the pump main body further includes an electric driver disposed in the tray box and electrically connected to the pump and the electrical connector.

In some embodiments, the pump main body further includes a control circuit board electrically connected between the electric driver and the electrical connector.

In some embodiments, the pump main body further includes a fan device disposed in the tray box, and the tray box defines a plurality of ventilation openings configured to allow cooling airflow generated by the fan device to pass therethrough.

This summary is provided to introduce a selection of concepts in a simplified form that are further described below in the Detailed Description. This summary is not intended to identify key features or essential features of the claimed subject matter, nor is it intended to be used to limit the scope of the claimed subject matter.

### BRIEF DESCRIPTION OF THE DRAWINGS

Various embodiments of this disclosure that are proposed as examples will be described in detail with reference to the following figures, wherein like numerals reference like elements, and wherein:
FIG. 1 is a perspective view of a liquid pump unit in accordance with one embodiment of the present disclosure.
FIG. 2 is an exploded view of the liquid pump unit of FIG. 1.
FIG. 3 is a cross-sectional view of the liquid pump unit of FIG. 1.
FIG. 4 is a side view of a latch mechanism and catch-pin of the liquid pump unit of FIG. 1.
FIG. 5 is another side view of the latch mechanism and catch-pin of the liquid pump unit of FIG. 1.
FIG. 6 is a cross-sectional view showing the pump assembly of the liquid pump unit of FIG. 1 before installation into the chassis box.
FIG. 7 is a cross-sectional view showing an abutment protrusion of the liquid pump unit of FIG. 1 being engaged by the catch-pin.
FIG. 8 is a cross-sectional view showing a hook of the liquid pump unit of FIG. 1 before engaging with a retaining cut-out.
FIG. 9 is a partially enlarged cross-sectional view showing the hook of the liquid pump unit of FIG. 1 before engaging with the retaining cut-out.
FIG. 10 is a cross-sectional view showing the hook of the liquid pump unit of FIG. 1 engaged with the retaining cut-out.

### DETAILED DESCRIPTION OF EMBODIMENTS

Various embodiments will be described in detail with reference to the drawings, wherein like reference numerals represent like parts and assemblies throughout the several views. Reference to various embodiments does not limit the scope of the claims attached hereto. Additionally, any examples set forth in this specification are not intended to be limiting and merely set forth some of the many possible embodiments for the appended claims.

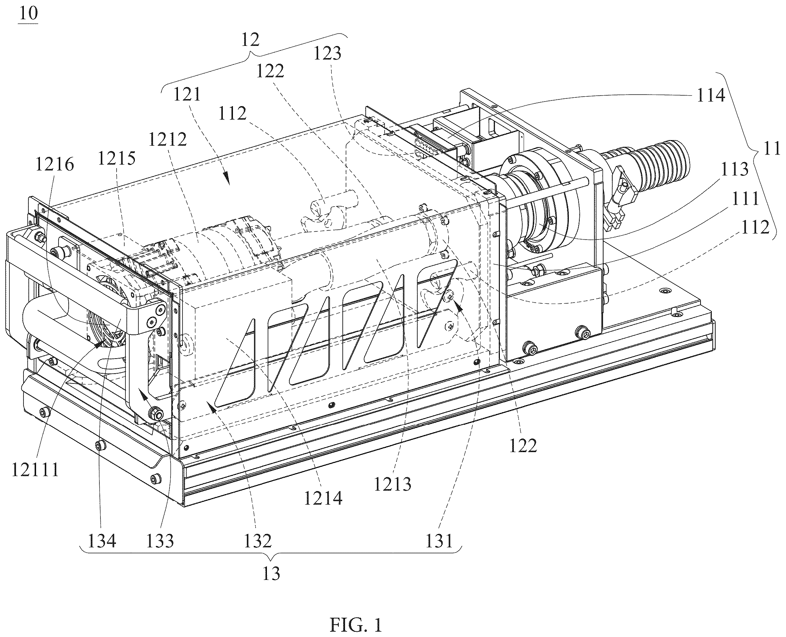

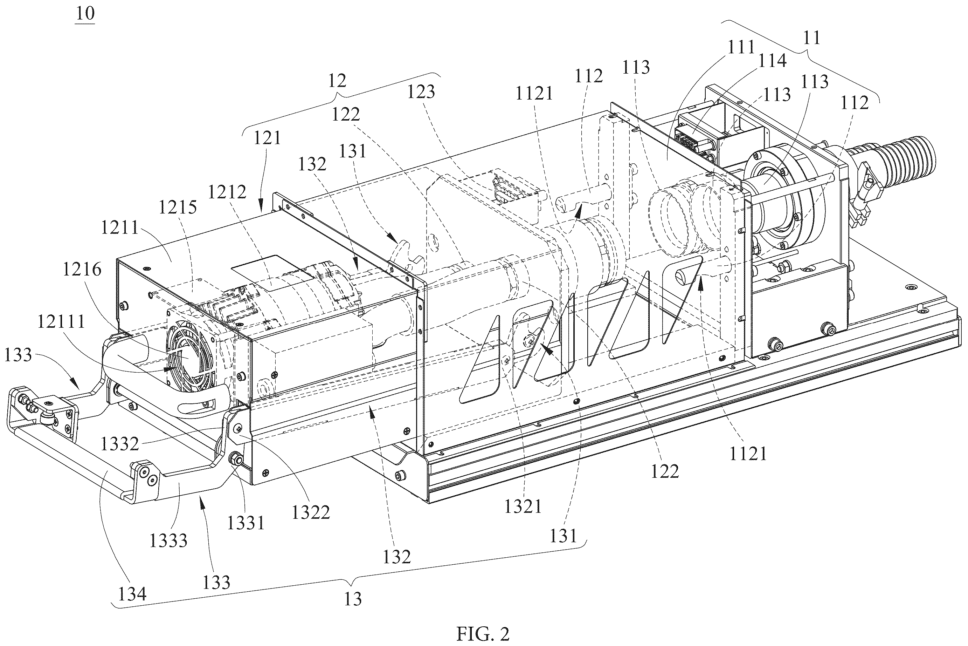

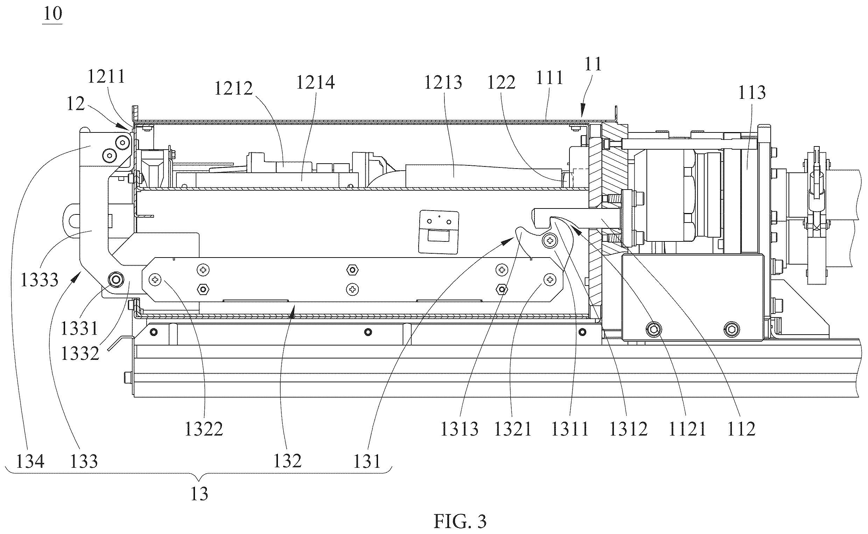

Referring to FIGS. 1 to 3, FIG. 1 is a perspective view of a liquid pump unit in accordance with one embodiment of the present disclosure. FIG. 2 is an exploded view of the liquid pump unit shown in FIG. 1. FIG. 3 is a cross-sectional view of the liquid pump unit shown in FIG. 1. As an example shown in FIG. 1, the liquid pump unit 10 of the present embodiment is a hot-swappable coolant distribution unit. Hot-swapping refers to the capability to insert or remove system components while the system is powered on and running, allowing the system to continue operating normally without interruption. The liquid pump unit 10 is configured to contain a cooling fluid (not shown) and includes a chassis 11, a pump assembly 12, and a latch mechanism 13.

In some embodiments, the chassis 11 includes a chassis box 111, two catch-pins 112, two first fluid connectors 113, and a first electrical connector 114. The two catch-pins 112, the two first fluid connectors 113, and the first electrical connector 114 are disposed on the chassis box 111. The pump assembly 12 includes a pump main body 121, two second fluid connectors 122, and a second electrical connector 123. The pump main body 121 is removably mounted in the chassis box 111 and includes a tray box 1211, a pump 1212, two connecting pipes 1213, an electric driver 1214, and a control circuit board 1215. The two second fluid connectors 122 and the second electrical connector 123 are disposed on the tray box 1211. The two second fluid connectors 122 are configured to fluidly communicate with the two first fluid connectors 113, respectively. The second electrical connector 123 is configured to electrically connect to the first electrical connector 114.

In some embodiments, the pump 1212 is disposed within the tray box 1211. The two connecting pipes 1213 are configured to connect the two second fluid connectors 122 to the pump 1212. The electric driver 1214 is disposed within the tray box 1211 and is electrically connected to the pump 1212 and the second electrical connector 123. The control circuit board 1215 is electrically connected to the second electrical connector 123 and the electric driver 1214. Through the control circuit board 1215, control signals are transmitted to the electric driver 1214, which then drives the pump 1212, resulting in the circulation of the cooling fluid through the pump 1212's driving action.

In some embodiments, the latch mechanism 13 includes two latches 131, two bars 132, two levers 133, and a handle 134. The two catch-pins 112 of the chassis 11 are symmetrically positioned on opposite sides within the chassis box 111. Correspondingly, the two latches 131, two levers 133, and two bars 132 of the latch mechanism 13 are symmetrically arranged on opposite sides within the tray box 1211 of the pump main body 121. Each catch-pin 112, latch 131, lever 133, and bar 132 bears the same structure as its counterpart. Therefore, the following description will use one catch-pin 112, one latch member 131, one lever member 133, and one bar member 132 as examples.

In some embodiments, the latch 131 is pivotally mounted at a location on the tray box 1211 of the pump main body 121. Specifically, the latch 131 includes a main body portion 1311, a hook 1312, and an abutment protrusion 1313. The main body portion 1311 is pivotally mounted at a location on the tray box 1211 of the pump main body 121 on a side adjacent to the hook 1312 and the abutment protrusion 1313. The hook 1312 and the abutment protrusion 1313 project from opposite sides of the main body portion 1311. Specifically, the catch-pin 112 has a retaining cut-out 1121. The hook 1312 is configured to removably engage with the retaining cut-out 1121. The abutment protrusion 1313 is configured to be abutted by a first end of the catch-pin 112 that is located further away from the chassis box 111.

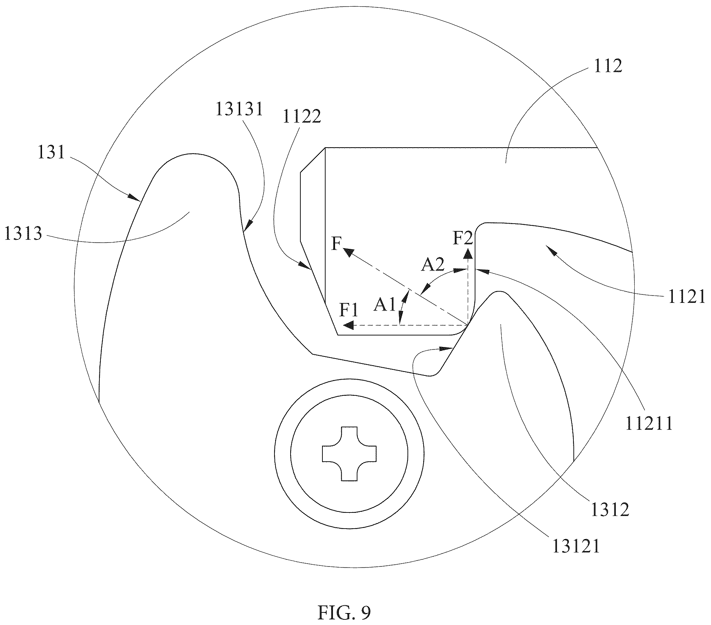

Reference is also made to FIG. 9. FIG. 9 is a partially enlarged cross-sectional view showing the hook of the liquid pump unit of FIG. 1 before engaging with the retaining cut-out. As an example illustrated in FIG. 9, the retaining cut-out 1121 has a first abutment surface 11211. The first end of the catch-pin 112 has a second abutment surface 1122 that faces away from the first abutment surface 11211. The hook 1312 has a third abutment surface 13121. The abutment protrusion 1313 has a fourth abutment surface 13131 that faces toward the third abutment surface 13121. When the abutment protrusion 1313 is abutted by the first end of the catch-pin 112, the second abutment surface 1122 abuts against the fourth abutment surface 13131. When the hook 1312 engages with the retaining cut-out 1121, the third abutment surface 13121 abuts against the first abutment surface 11211.

In some embodiments, the bar 132 includes opposing first and second pivot ends 1321 and 1322, respectively. A main body portion 1311 is pivotally connected to the first pivot end 1321 at an end opposite to either the hook 1312 or the abutment protrusion 1313. This configuration allows the bar 132 to drive the abutment protrusion 1313 into abutment with the first end of the catch-pin 112, assisting in the rotation of the latch 131. As a result, the hook 1312 engages the retaining cut-out 1121, the two second fluid connectors 122 are respectively fluidly connected to the two first fluid connectors 113, and the second electrical connector 123 is electrically coupled to the first electrical connector 114.

In some embodiments, the lever 133 is pivotally mounted at the other end of the bar 132 opposite to the latch 131 on the tray box 1211. Specifically, the lever 133 includes a pivot portion 1331, an extension portion 1332, and an operating portion 1333. The pivot portion 1331 is pivotally mounted to the tray box 1211 such that the rotational axis of the latch 131 is not coaxial with the rotational axis of the lever 133. The extension portion 1332 and the operating portion 1333 extend from the pivot portion 1331 in different directions. The extension portion 1332 is pivotally connected to the second pivot end 1322, while the operating portion 1333 is configured to rotate the lever 133 relative to the tray box 1211, leading the bar 132 and the latch 131 to rotate and causing the latch 131 to engage the retaining cut-out 1121. The extension portion 1332 and the operating portion 1333 are not coaxial. A handle 134 is connected between the operating portions 1333 of the two levers 133, allowing it to drive both levers 133 at the same time.

In some embodiments, when the pump assembly 12 is pushed toward the chassis 11, rotation of the lever 133 relative to the pump assembly 12, together with the abutment of the abutment protrusion 1313 by the first end of the catch-pin 112, cooperatively drives the hook 1312 to engage the retaining cut-out 1121.

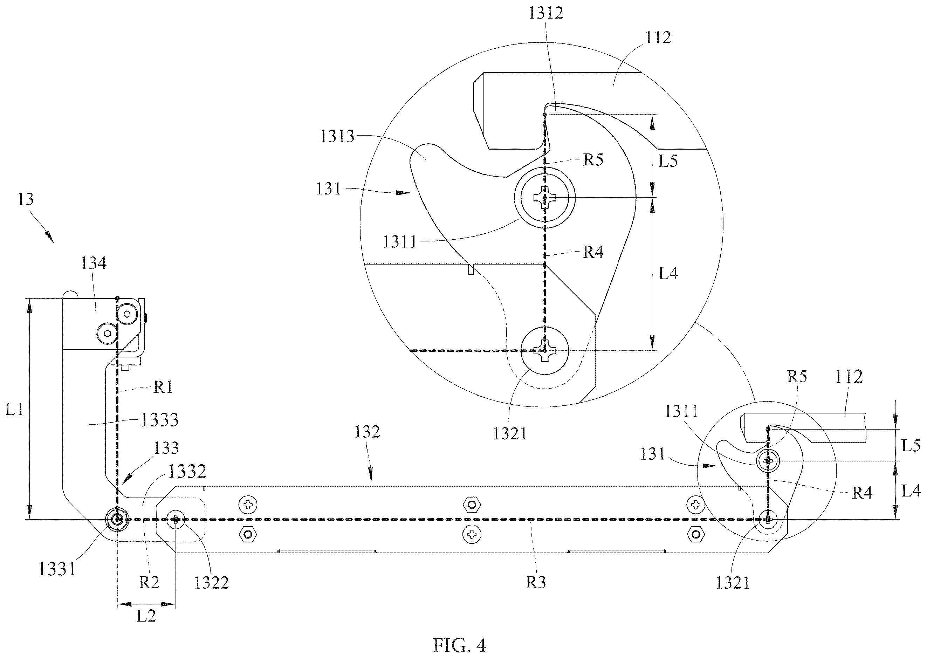

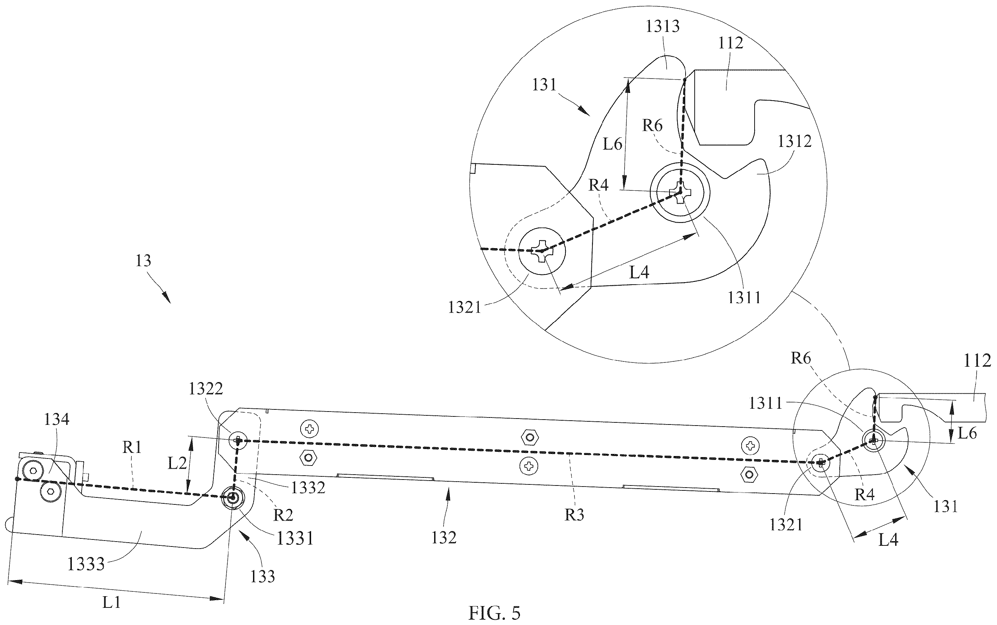

Referring to FIGS. 4-5, FIG. 4 is a side view of a latch mechanism and catch-pin of the liquid pump unit of FIG. 1. FIG. 5 is another side view of the latch mechanism and catch-pin of the liquid pump unit of FIG. 1.

In some embodiments, a first connecting line R1 extends between one side of the handle 134 connected to lever 133 and a pivot portion 1331 pivotally mounted to the tray box 1211. A length of the first connecting line R1 is L1. A second connecting line R2 extends between the pivot portion 1331 pivotally mounted to the tray box 1211 and an extension portion 1332 pivotally mounted to a second pivot end 1322. A length of the second connecting line R2 is L2. For example, the length L1 is greater than or equal to 1.1 times the length L2. A third connecting line R3 extends between the extension portion 1332 pivotally mounted to the second pivot end 1322 and a main body portion 1311 pivotally mounted to a first pivot end 1321. A length of the third connecting line R3 is L3. A fourth connecting line R4 extends between the main body portion 1311 pivotally mounted to the first pivot end 1321 and the main body portion 1311 pivotally mounted to the tray box 1211. A length of the fourth connecting line R4 is L4. A fifth connecting line R5 extends between the main body portion 1311 pivotally mounted to the tray box 1211 and a hook 1312 abutting against a retaining cut-out 1121. A length of the fifth connecting line R5 is L5. A sixth connecting line R6 extends between the main body portion 1311 pivotally mounted to the tray box 1211 and an abutment protrusion 1313 abutting against a catch-pin 112. A length of the sixth connecting line R6 is L6. For example, the length L4 is greater than or equal to 1.1 times the length L5. The length L4 is also greater than or equal to 1.1 times the length L6.

In some embodiments, as illustrated in FIG. 9, an angle (not labeled) between the fifth connecting line R5 and the sixth connecting line R6 determines whether a third abutment surface 13121 abuts against a first abutment surface 11211, or whether a second abutment surface 1122 abuts against a fourth abutment surface 13131, indicating the installation and removal of the pump assembly 12 relative to the chassis 11. For example, in one embodiment, the angle between the fifth connecting line R5 and the sixth connecting line R6 can be greater than or equal to 10 degrees and less than or equal to 90 degrees. In another example, the angle between the fifth connecting line R5 and the sixth connecting line R6 may be greater than or equal to 45 degrees and less than or equal to 90 degrees. When the angle between the fifth connecting line R5 and the sixth connecting line R6 is about 45 degrees, the third abutment surface 13121 abuts against the first abutment surface 11211, causing the hook 1312 to engage with the retaining cut-out 1121. Furthermore, when the angle between the fifth connecting line R5 and the sixth connecting line R6 is about 90 degrees, the second abutment surface 1122 abuts against the fourth abutment surface 13131, causing the hook 1312 to disengage from the retaining cut-out 1121. This configuration allows the hook 1312 to be easily engaged and disengaged from the retaining cut-out 1121.

Based on the configuration described above, the pump assembly 12 can be installed or removed from the chassis 11 without a need to open the chassis 11 or perform time-consuming assembly and disassembly operations with extra tools or components. In some embodiments, the two first fluid connectors 113 and two second fluid connectors 122 can be connected or disconnected at same time, as can the first electrical connector 114 and second electrical connector 123 via the engagement or disengagement between the latch 131 and the catch-pin 112, completing the installation or removal of the pump assembly 12. Further, the abutment protrusion 1313 assists in rotating the latch 131, enabling smooth engagement of the hook 1312 with the retaining cut-out 1121. Therefore, the ease of assembling and disassembling the liquid pump unit 10 is significantly enhanced.

In some embodiments, the pump main body 121 may further include a fan device 1216 (shown in FIGS. 1-2), and the tray box 1211 of the pump main body 121 may further include multiple ventilation openings 12111 (shown in FIGS. 1-2). The fan device 1216 is disposed in the tray box 1211 and configured to generate a cooling airflow through the ventilation openings 12111 to dissipate heat from the internal space of the pump main body 121.

According to the embodiments, the combination of the latch 131, bar 132, and lever 133 enables smooth engagement of the hook 1312 with the retaining cut-out 1121. However, the embodiment is not limited thereto. In other embodiments, alternative mechanical combinations such as gears, chains, pulleys, or helical rods may also be utilized to facilitate seamless engagement between the hook and the retaining cut-out.

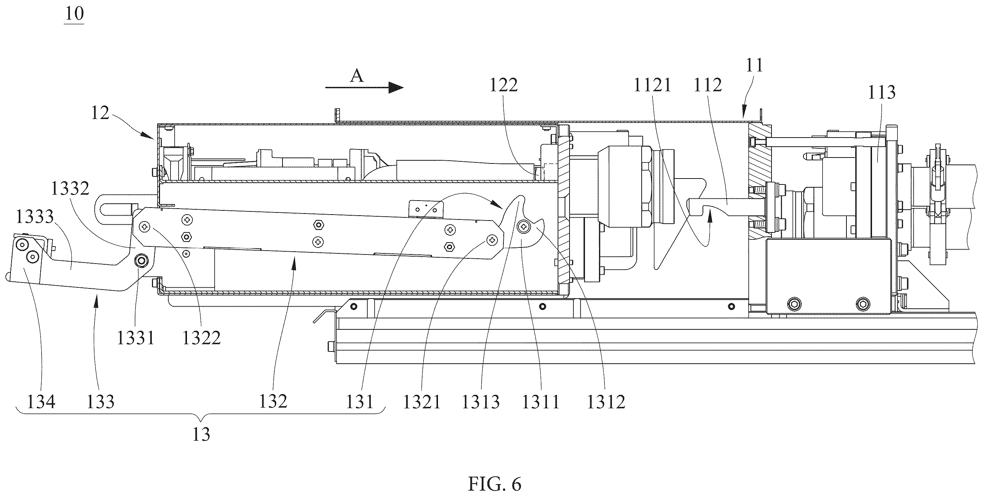

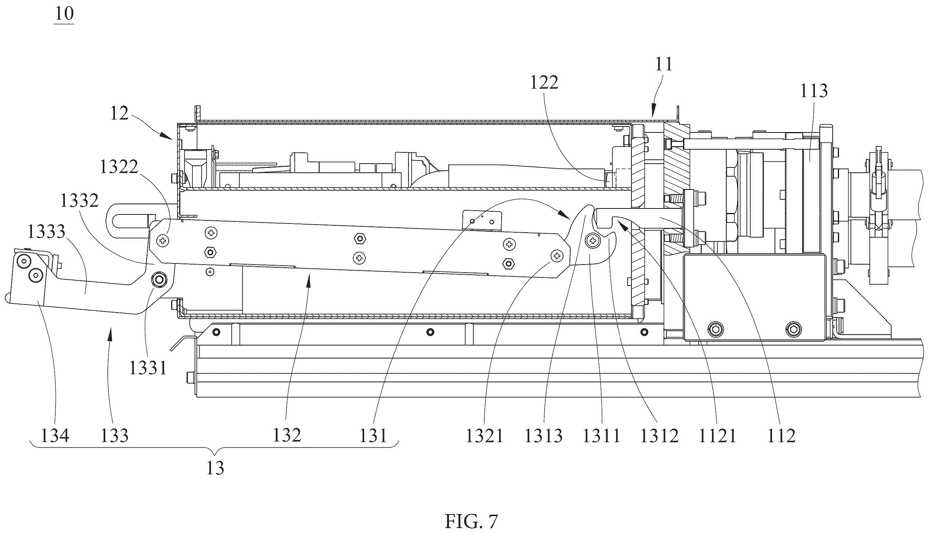

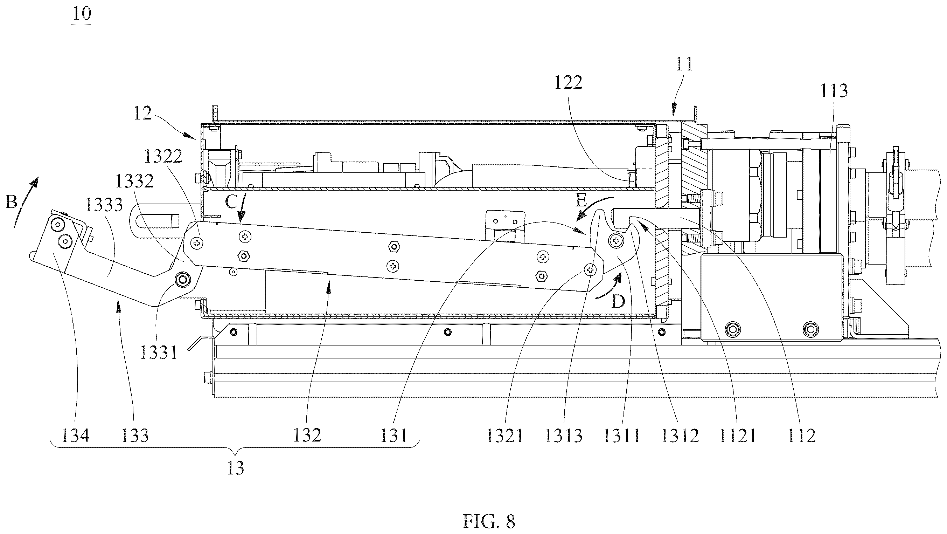

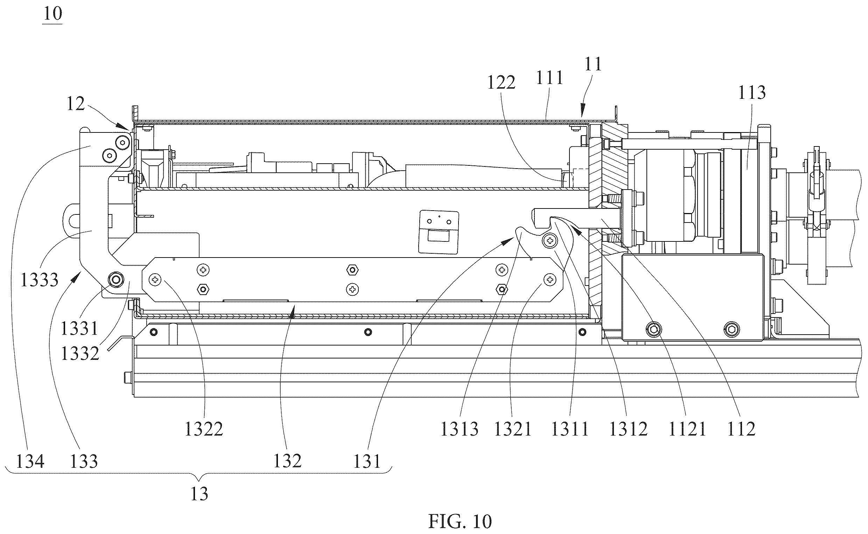

Referring to FIGS. 6-10, FIG. 6 is a cross-sectional view showing the pump assembly of the liquid pump unit of FIG. 1 before installation into the chassis box. FIG. 7 is a cross-sectional view showing an abutment protrusion of the liquid pump unit of FIG. 1 being engaged by the catch-pin. FIG. 8 is a cross-sectional view showing a hook of the liquid pump unit of FIG. 1 before engaging with a retaining cut-out. FIG. 9 is a partially enlarged cross-sectional view showing the hook of the liquid pump unit of FIG. 1 before engaging with the retaining cut-out. FIG. 10 is a cross-sectional view showing the hook of the liquid pump unit of FIG. 1 engaged with the retaining cut-out.

In some embodiments, when a user intends to install the pump assembly 12 into the chassis 11, as shown in FIGS. 6 and 7, the pump assembly 12 is first pushed into the chassis 11 along direction A. Subsequently, as shown in FIG. 8, the handle 134 is rotated in direction B. During this rotation, the handle 134 drives the second pivot end 1322 and the first pivot end 1321 of the bar 132 to rotate along directions C and D, respectively, causing the latch 131 to rotate along direction E via linkage with the bar 132. As a result, the latch 131 engages with the retaining cut-out 1121 of the catch-pin 112.

As an example shown in FIG. 9, when the latch 131 rotates in direction E, the abutment protrusion 1313 is first pressed by the first end of the catch-pin 112, facilitating the rotation of the latch 131 and enabling the user to push the pump assembly 12 with reduced effort. Subsequently, the hook 1312 comes into contact with an opening of the retaining cut-out 1121, generating a reaction force F between the two . The reaction force F can be decomposed into a horizontal component F1 and a vertical component F2, which are perpendicular to one another. An angle A1 between the horizontal component F1 and the reaction force F is smaller than an angle A2 between the vertical component F2 and the reaction force F, indicating that the horizontal component F1 exceeds the vertical component F2. With this force relationship, the user can more readily engage the latch 131 with the retaining cut-out 1121. Finally, as illustrated in FIG. 10, the latch 131 is securely engaged with the retaining cut-out 1121, completing the installation of the pump assembly 12 into the chassis 11.

In some embodiments, when the user intends to remove the pump assembly 12 from the chassis 11, the handle 134 is first rotated in a direction opposite to direction B. During this operation, the second pivot end 1322 and the first pivot end 1321 of the bar 132 are driven by the handle 134 to rotate in directions opposite to directions C and D, respectively, causing the latch 131 to rotate in a direction opposite to direction E. As a result, the latch 131 is disengaged from the retaining cut-out 1121. The pump assembly 12 is then pulled out of the chassis 11 in a direction opposite to direction A, completing its removal from the chassis 11.

According to the present disclosure, the pump assembly 12 can be installed or removed without opening the chassis 11 or requiring additional assembly and removal components. Instead, the two first fluid connectors 113 and the two second fluid connectors 122 can be concurrently fluidly connected or disconnected, while the first electrical connector 114 and the second electrical connector 123 can be simultaneously electrically connected or disconnected via direct engagement or disengagement between the latch 131 and the catch-pin 112. Further, the abutment protrusion 1313 facilitates rotation of the latch 131, allowing for seamless engagement and disengagement of the hook 1312 with respect to the retaining cut-out 1121. Therefore, the ease of assembling and disassembling the liquid pump unit 10 can be significantly enhanced.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified. Of course, the disclosed embodiments are merely exemplary embodiments and that various modifications can be made. Further, it should be understood that various aspects of the embodiment are not mutually exclusive of each other and can be combined as desired by a person of ordinary skill in the art as a matter of design choices.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

Reference Signs:
10: liquid pump unit
11: chassis
111: chassis box
112: catch-pin
1121: retaining cut-out
11211: first abutment surface (of retaining cut-out)
1122: second abutment surface (of catch-pin)
113: first fluid connector
114: first electrical connector
12: pump assembly
121: pump main body
1211: tray box
12111: ventilation openings
1212: pump
1213: connecting pipe
1214: electric driver
1215: control circuit board
1216: fan device
122: second fluid connector
123: second electrical connector
13: latch mechanism
131: latch
1311: main body portion (of latch)
1312: hook
13121: third abutment surface (of hook)
1313: abutment protrusion
13131: fourth abutment surface (of abutment protrusion)
132: bar
1321: first pivot end (of bar)
1322: second pivot end (of bar)
133: lever
1331: pivot portion (of lever)
1332: extension portion (of lever)
1333: operating portion (of lever)
134: handle
R1: first connecting line
L1: length of the first connecting line
R2: second connecting line
L2: length of the second connecting line
R4: fourth connecting line
L4: length of the fourth connecting line
R5: fifth connecting line
L5: length of the fifth connecting line
R6: sixth connecting line
L6: length of the sixth connecting line

## Claims

1. A liquid pump unit (10), comprising:
a chassis (11) including a chassis box (111) and a catch-pin (112) disposed on the chassis box (111), the catch-pin (112) having a retaining cut-out (1121);
a pump assembly (12) removably mounted in the chassis box (111); and
a latch mechanism (13), including:
a latch (131) having a main body portion (1311), a hook (1312), and an abutment protrusion (1313), the main body portion (1311) being pivotally mounted at a first location of the pump assembly (12), and the hook (1312) and the abutment protrusion (1313) being projected from opposite sides of the main body portion (1311);
a lever (133) including a pivot portion (1331) and an extension portion (1332), the pivot portion (1331) being pivotally mounted at a second location on the pump assembly (12), and the extension portion (1332) being connected to the pivot portion (1331); and
a bar (132) having opposite first and second pivot ends (1321, 1322) that are pivotally connected to the main body portion (1311) of the latch (131) and the extension portion (1332) of the lever (133), respectively;
wherein rotation of the lever (133) relative to the pump assembly (12) and abutment of the abutment protrusion (1313) against the catch-pin (112) cooperatively drive the hook (1312) to engage with the retaining cut-out (1121).

2. The liquid pump unit (10) of claim 1, wherein the retaining cut-out (1121) has a first abutment surface (11211), a first end of the catch-pin (112) remote from the chassis box (111) has a second abutment surface (1122), the first abutment surface (11211) faces away from the second abutment surface (1122), the hook (1312) has a third abutment surface (13121), the abutment protrusion (1313) has a fourth abutment surface (13131), the third abutment surface (13121) faces toward the fourth abutment surface (13131), when the abutment protrusion (1313) is abutted by the catch-pin (112), the second abutment surface (1122) abuts against the fourth abutment surface (13131), and when the hook (1312) engages with the retaining cut-out (1121), the third abutment surface (13121) abuts against the first abutment surface (11211).

3. The liquid pump unit (10) of claim 1, wherein the chassis (11) further includes a first fluid connector (113) and a first electrical connector (114) that are disposed in the chassis box (111), the pump assembly (12) includes a pump main body (121), a second fluid connector (122), and a second electrical connector (123), the pump main body (121) is removably mounted in the chassis box (111), the second fluid connector (122) and the second electrical connector (123) are disposed in the pump main body (121), and rotation of the lever (133) drives the hook (1312) to engage with the retaining cut-out (1121) via the bar (132), thereby causing the second fluid connector (122) to fluidly communicate with the first fluid connector (113) and the second electrical connector (123) to electrically connect with the first electrical connector (114).

4. The liquid pump unit (10) of claim 3, wherein the pump main body (121) includes a tray box (1211), a pump (1212), and an electric driver (1214), the second fluid connector (122), the second electrical connector (123), the pump (1212), and the electric driver (1214) are disposed in the tray box (1211), and the electric driver (1214) is electrically connected to the pump (1212) and to the second electrical connector (123).

5. The liquid pump unit (10) of claim 4, wherein the pump main body (121) further includes a connecting pipe (1213) configured to connect the second fluid connector (122) to the pump (1212).

6. The liquid pump unit (10) of claim 4, wherein the main body portion (1311) is pivotally mounted at one location on the tray box (1211) at a side adjacent to the hook (1312) and the abutment protrusion (1313), the pivot portion (1331) is pivotally mounted at another location on the tray box (1211), the first pivot end (1321) being pivotally connected to the main body portion (1311) at a side opposite to the hook (1312) and the abutment protrusion (1313), and the second pivot end (1322) being pivotally connected to the extension portion (1332) of the lever (133).

7. The liquid pump unit (10) of claim 6, wherein the lever (133) further includes an operating portion (1333) connected to the pivot portion (1331) and projecting in a direction different from the extension portion (1332), the operating portion (1333) being configured to drive the lever (133) to rotate relative to the tray box (1211).

8. The liquid pump unit (10) of claim 7, wherein the latch mechanism (13) further includes a handle (134), the lever (133) drives the latch (131) through the bar (132), and the handle (134) is connected to the operating portion (1333) of the lever (133) to enable actuation of the lever (133).

9. The liquid pump unit (10) of claim 8, wherein:
a first connecting line (R1) extends between a side of the handle (134) remote from the operating portion (1333) and the pivot portion (1331) pivotally mounted on the tray box (1211),
a second connecting line (R2) extends between the pivot portion (1331) pivotally mounted on the tray box (1211) and the extension portion (1332) pivotally connected to the second pivot end (1322), and
a length (L1) of the first connecting line (R1) is greater than or equal to 1.1 times a length (L2) of the second connecting line (R2).

10. The liquid pump unit (10) of claim 8, wherein:
a fourth connecting line (R4) extends between the main body portion (1311) pivotally connected to the first pivot end (1321) and the main body portion (1311) pivotally mounted on the tray box (1211),
a fifth connecting line (R5) extends between the main body portion (1311) pivotally mounted on the tray box (1211) and the hook (1312) abutting against the retaining cut-out (1121),
a sixth connecting line (R6) extends between the main body portion (1311) pivotally mounted on the tray box (1211) and the abutment protrusion (1313) abutting against the catch-pin (112),
a length (L4) of the fourth connecting line (R4) is greater than or equal to 1.1 times a length (L5) of the fifth connecting line (R5), and
the length (L4) of the fourth connecting line (R4) is greater than or equal to 1.1 times a length (L6) of the sixth connecting line (R6).

11. The liquid pump unit (10) of claim 10, wherein an angle between the fifth connecting line (R5) and the sixth connecting line (R6) is greater than or equal to 10 degrees and less than or equal to 90 degrees.

12. The liquid pump unit (10) of claim 4, wherein the pump main body (121) further includes a control circuit board (1215) electrically connected to the second electrical connector (123) and the electric driver (1214).

13. The liquid pump unit (10) of claim 4, wherein the tray box (1211) includes multiple ventilation openings (12111), and the pump main body (121) further includes a fan device (1216) disposed on the tray box (1211) and configured to generate cooling airflow passing through the ventilation openings (12111).

14. A pump assembly (12) for a liquid cooling system, comprising:
a pump main body (121) including a tray box (1211), a pump (1212) disposed in the tray box (1211), a fluid connector (122) disposed in the tray box (1211), and an electrical connector (123) disposed in the tray box (1211);
a latch mechanism (13), including:
a latch (131) having a main body portion (1311), a hook (1312), and an abutment protrusion (1313), the main body portion (1311) being pivotally mounted on the tray box (1211), and the hook (1312) and the abutment protrusion (1313) being projected from opposite sides of the main body portion (1311);
a lever (133) including a pivot portion (1331) mounted on the tray box (1211) and an extension (1332) connected to the pivot portion (1331); and
a bar (132) pivotally connecting the main body portion (1311) to the extension portion (1332);
wherein the lever (133) is configured to drive the latch (131) through the bar (132) to engage the hook (1312) with a retaining cut-out (1121) of a catch-pin (112).

15. The pump assembly (12) of claim 14, wherein the hook (1312) has an abutment surface (13121) configured to abut against a corresponding abutment surface (11211) of the retaining cut-out (1121) when the hook (1312) engages with the retaining cut-out (1121).

16. The pump assembly (12) of claim 14, wherein the lever (133) further includes an operating portion (1333) connected to the pivot portion (1331) and extending in a direction different from the extension portion (1332).

17. The pump assembly (12) of claim 16, wherein the latch mechanism (13) further includes a handle (134) connected to the operating portion (1333) and configured to drive rotation of the lever (133).

18. The pump assembly (12) of claim 14, wherein the pump main body (121) further includes an electric driver (1214) disposed in the tray box (1211) and electrically connected to the pump (1212) and the electrical connector (123).

19. The pump assembly (12) of claim 18, wherein the pump main body (121) further includes a control circuit board (1215) electrically connected between the electric driver (1214) and the electrical connector (123).

20. The pump assembly (12) of claim 14, wherein the pump main body (121) further includes a fan device (1216) disposed in the tray box (1211), and the tray box (1211) defines a plurality of ventilation openings (12111) configured to allow cooling airflow generated by the fan device (1216) to pass therethrough.
